# EUROPEAN PATENT APPLICATION

(11) **EP 4 618 154 A1**
(43) Date of publication of application: **17.09.2025**
(21) Application number: 23888372.2
(22) Date of filing: 26.09.2023
(51) Int. Cl.: H01L 27/12, H01L 21/02

(54) **SUBSTRATE FOR HIGH FREQUENCY DEVICES AND METHOD FOR PRODUCING SAME**

(30) Priority: 11.11.2022 JP 2022181395
(71) Applicant: Shin-Etsu Handotai Co., Ltd., Tokyo 100-0004 (JP)
(72) Inventor: HAGIMOTO, Kazunori, Annaka-shi, Gunma 379-0196 (JP)
(74) Representative: Schicker, Silvia
(86) International application number: PCT/JP2023/034915
(87) International publication number: WO 2024/101019

(57) **Abstract**

The present invention is a high-frequency device substrate including an SOI substrate with a nitride semiconductor film formed thereon. The SOI substrate is a TRSOI substrate in which a trap rich layer formed on a base substrate and an SOI layer composed of a silicon single crystal are bonded via an oxide film. The SOI layer has a resistivity of 1k Ω·cm or more, a crystal plane orientation of (111), and an oxygen concentration of 14.8 ppma or less. Thereby, a high-frequency device substrate having excellent high-frequency characteristics and a method for producing the same are provided.

## Description

### TECHNICAL FIELD

The present invention relates to a high-frequency device substrate and a method for producing the same.

### BACKGROUND ART

Nitride semiconductors typified by GaN are expected as next-generation semiconductor materials that exceed the limit of Si as a material. In recent years, high-frequency devices have been manufactured by epitaxially growing a nitride semiconductor on a silicon single crystal substrate. In the high-frequency devices, characteristic deterioration caused by a substrate, loss and second/third harmonic characteristics deterioration due to a substrate are observed.

In general, a high-resistivity substrate is used as a high-frequency device substrate, and a GaN layer or the like is epitaxially grown thereon to manufacture a high-frequency device. A high-resistivity substrate is used to prevent signals flowing from the epitaxial layer to an underlying Si substrate. In addition, when a nitride semiconductor epitaxial layer is laminated on a high-resistivity silicon substrate, the nitride semiconductor epitaxial layer is laminated by devising a buffer layer as a stress relaxation layer.

Further, as described in Patent Documents 1 and 2, a TR substrate provided with a TR (trap rich) layer is generally used as a high-frequency device substrate, and frequency characteristics are improved by using a high-resistivity substrate. Patent Document 1 and the like describe a structure in which a TR layer, a dielectric layer (buried oxide film), and a semiconductor layer are formed on a high-resistivity base substrate.

### CITATION LIST

### PATENT LITERATURE

Patent Document 1: JP 7098851 B
Patent Document 2: JP 2022-70890 A

### SUMMARY OF INVENTION

### TECHNICAL PROBLEM

In high-frequency devices using a normal TR substrate, there is a limit to the improvement of the second harmonic (2HD), and in order to further improve the high-frequency characteristics, a GaN on TRSOI substrate produced by combining a TRSOI substrate and a GaN layer having excellent high-frequency characteristics is considered to be promising.

However, even in the GaN on TRSOI substrate in which the GaN layer is laminated on the TRSOI substrate, the second harmonic characteristics were not improved due to the influence of characteristics of a Si substrate (resistivity and oxygen concentration) in some cases.

The present invention was made to solve the above problem, and has its object to provide a high-frequency device substrate having excellent high-frequency characteristics and a method for producing the same.

### SOLUTION TO PROBLEM

To achieve the above object, the present invention provides a high-frequency device substrate comprising an SOI substrate with a nitride semiconductor film formed thereon, wherein
the SOI substrate is a TRSOI substrate in which a trap rich layer formed on a base substrate and an SOI layer composed of a silicon single crystal are bonded via an oxide film, and
the SOI layer has a resistivity of 1k Ω·cm or more, a crystal plane orientation of (111), and an oxygen concentration of 14.8 ppma or less.

Thus, in the case where a substrate with a nitride semiconductor film formed thereon is a TRSOI substrate, and an SOI layer of the TRSOI substrate has a high resistivity of 1k Ω·cm or more as described above, and the oxygen concentration is within the above numerical range, it is possible to obtain a high-frequency device substrate having excellent high-frequency characteristics. For example, in conventional products (such as a TR substrate), the 2HD is at most about -91 dBm. In the present invention, however, the 2HD can be further reduced, and more excellent harmonic characteristics can be exhibited.

In addition, because the SOI layer has the above crystal plane orientation, the nitride semiconductor film on the SOI layer is favorably formed.

In this case, the SOI layer may have an oxygen concentration of 5.2 ppma or less, and the high-frequency characteristics can be further improved.

Furthermore, the SOI layer may have an oxygen concentration of 0.5 ppma or less, and the high-frequency characteristics can be still further improved.

The base substrate may be a CZ silicon single crystal substrate having a crystal plane orientation of (100).

A base substrate having (100) crystal plane orientation obtained by the CZ method tends to have a good production yield, is inexpensive, and has high quality, and thus an inexpensive and high-precision high-frequency device substrate can be provided.

Additionally, the base substrate may have a resistivity of 1k Ω·cm or more.

When the base substrate has such a high resistivity of 1k Ω·cm or more, the high-frequency characteristics can be further improved.

Moreover, the present invention provides a method for producing a high-frequency device substrate comprising an SOI substrate with a nitride semiconductor film formed thereon, the method comprising:
a step of providing, as the SOI substrate, a TRSOI substrate in which in a bonded substrate obtained by bonding a trap rich layer formed on a base substrate and a bond substrate composed of a silicon single crystal via an oxide film, the bond substrate is thinned to form an SOI layer; and
a step of forming the nitride semiconductor film on the SOI layer, wherein
the bond substrate has a resistivity of 1k Ω·cm or more, a crystal plane orientation of (111), and an oxygen concentration of 14.8 ppma or less.

According to such a production method of the present invention, a high-frequency device substrate having excellent high-frequency characteristics (for example, second harmonic characteristics) can be produced, and a nitride semiconductor film can also be favorably formed.

In this case, a substrate having an oxygen concentration of 5.2 ppma or less can be used as the bond substrate, and more excellent high-frequency characteristics may be provided.

Further, a substrate having an oxygen concentration of 0.5 ppma or less can be used as the bond substrate, and still more excellent high-frequency characteristics may be provided.

A CZ silicon single crystal substrate having a crystal plane orientation of (100) may be used as the base substrate.

A high-quality base substrate with (100) crystal plane orientation can be prepared at a low cost.

In addition, a substrate having a resistivity of 1k Ω·cm or more may be used as the base substrate.

Thus, it is possible to obtain a substrate having more excellent high-frequency characteristics.

### ADVANTAGEOUS EFFECTS OF INVENTION

According to the high-frequency device substrate and the method for producing the same of the present invention, it is possible to obtain a high-frequency device substrate having excellent high-frequency characteristics such as 2HD.

### BRIEF DESCRIPTION OF DRAWINGS

FIG. 1 is a schematic explanatory diagram illustrating a high-frequency device substrate according to an embodiment of the present invention;
FIG. 2 is a process drawing showing a method for producing the high-frequency device substrate according to an embodiment of the present invention;
FIG. 3 is a schematic structural view showing an example of a composite in which a CPW electrode is formed on the high-frequency device substrate;
FIG. 4 is a schematic plan view of the CPW electrode; and
FIG. 5 is a graph showing measurement results of harmonic characteristics (2HD) of Examples 1 to 3 and Comparative Examples 1 to 3.

### DESCRIPTION OF EMBODIMENTS

Hereinafter, embodiments of the present invention will be described with reference to the drawings, but the present invention is not limited thereto.

Firstly, as described above, the present invention relates to a high-frequency device substrate having an SOI structure. In particular, the present invention relates to a high-frequency device substrate having a supporting substrate (base substrate) that resists formation of an inversion layer in a region close to an oxide film (i.e., a buried oxide film: BOX film) of the SOI structure.

A high resistivity semiconductor substrate (e.g., a silicon wafer) is susceptible to the formation of a highly conductive charge inversion layer or a charge accumulation layer at the interface between the BOX film and the supporting substrate. Thus, an effective resistivity of the substrate decreases, resulting in parasitic power losses and device non-linearity when the device is operated at RF frequencies.

Methods have been developed to trap charge in any induced inversion layer (or accumulation layer) for maintaining a high resistivity of the substrate even in a region very close to the surface. It is known that the performance of RF devices manufactured using an SOI substrate is improved by providing a charge trapping layer (CTL) between a high resistivity supporting substrate and the buried oxide layer. A plurality of methods for forming such an interfacial layer having high trapping properties have been proposed. For example, one of methods for forming a semiconductor-on-insulator (e.g., a silicon-on-insulator, that is, SOI) having a charge trapping layer in RF device applications is based on a step of depositing an undoped (non-doped) polycrystalline silicon film on a high resistivity silicon substrate, and a step of forming a laminate of an oxide film and an overlying silicon layer. The polycrystalline silicon layer functions as a highly defective layer between the silicon substrate and the buried oxide film.

Academic research shows that providing a polycrystalline silicon layer between the oxide film and the substrate improves device isolation, reduces transmission line losses, and reduces harmonic distortion. See, for example, the following references:
H. S. Gamble, et al. "Low-loss CPW lines on surface stabilized high resistivity silicon," Microwave Guided Wave Lett., 9(10), pp. 395-397, 1999;
D. Lederer, R. Lobet and J.-P. Raskin, "Enhanced high resistivity SOI wafers for RF applications," IEEE Intl. SOI Conf., pp. 46-47, 2004;
D. Lederer and J.-P. Raskin, "New substrate passivation method dedicated to high resistivity SOI wafer fabrication with increased substrate resistivity," IEEE Electron Device Letters, vol. 26, no. 11, pp. 805-807, 2005;
D. Lederer, B. Aspar, C. Laghae and J.-P. Raskin, "Performance of RF passive structures and SOI MOSFETs transferred on a passivated HR SOI substrate," IEEE International SOI Conference, pp. 29-30, 2006; and
Daniel C. Kerretal. "Identification of RF harmonic distortion on Si substrates and its reduction using a trap-rich layer," Silicon Monolithic Integrated Circuits in RF Systems, 2008. SiRF 2008 (IEEE Topical Meeting), pp. 151-154, 2008.

Conventionally, a TR substrate or the like as described in Patent Document 1 or the like have been used as a high-frequency device substrate to improve the high-frequency characteristics, but the improvement has been limited (for example, -91 dBm in 2HD).

Under such circumstances, as a result of intensive studies by the present inventor, it was found that, in a high-frequency device substrate (TRSOI substrate + nitride semiconductor film) such as GaN on TRSOI, the improvement of the high-frequency characteristics depends on the oxygen concentration of the SOI layer. Then, the present inventor found that when the oxygen concentration in the SOI layer (with a high resistivity [1k Ω·cm or more] and a crystal plane orientation of (111)) is 14.8 ppma or less, more excellent high-frequency characteristics are exhibited, thereby completing the present invention.

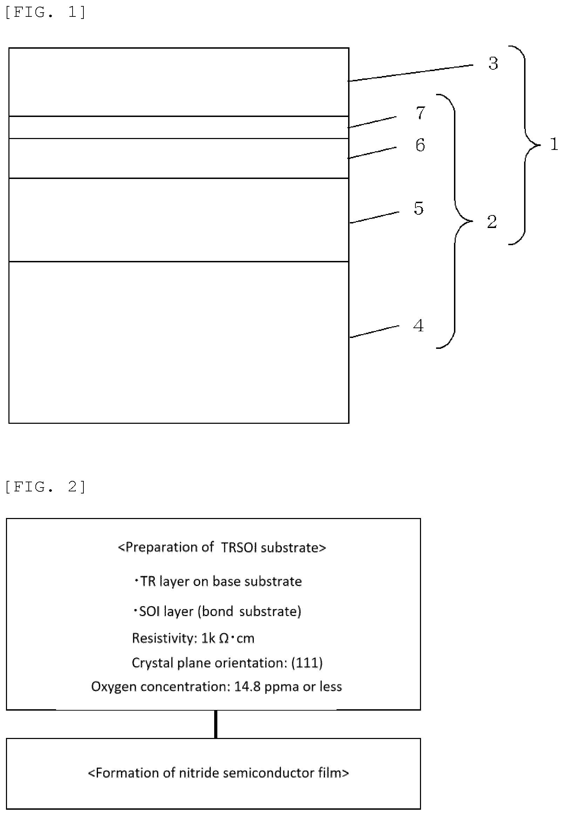

The high-frequency device substrate of the present invention will be described. FIG. 1 illustrates the high-frequency device substrate according to an embodiment of the present invention. A high frequency device substrate 1 of the present invention includes an SOI substrate 2 and a nitride semiconductor film 3 on the SOI substrate 2. The SOI substrate 2 has a structure in which a trap rich layer 5 (TR layer), an oxide film 6 (buried oxide film (BOX film)), and an SOI layer 7 (silicon single crystal layer) are sequentially laminated on a base substrate 4.

Hereinafter, each part will be described in detail.

The SOI substrate 2 is a TRSOI substrate in which the TR layer 5 formed on the base substrate 4 and the SOI layer 7 are bonded via the oxide film 6. For example, the above TRSOI substrate structure can be obtained by: forming the oxide film 6 on either one or both surfaces of a surface of a structure composed of the base substrate 4 and the TR layer 5 and a surface of a bond substrate to be the SOI layer 7; bonding them with each other; and thinning the bond substrate.

The base substrate 4 may be, for example, a silicon substrate, and in particular, may be a silicon single crystal substrate having the crystal plane orientation of (100) obtained by the CZ method. This is because it is easy to prepare an inexpensive and high-quality substrate.

The resistivity of the base substrate 4 is not particularly limited, and in order to easily control warpage, a low resistivity base substrate having a large breaking load may be used. By increasing a dopant concentration, strength of the base substrate is increased, and the warpage can be suppressed. On the other hand, a substrate having high resistivity, e.g., 1k Ω·cm or more, may also be used, and in this case, it is possible to obtain a high-frequency device substrate having more excellent high-frequency characteristics. The resistivity is preferably 3k Ω·cm or more, and more preferably 5k Ω·cm or more, for obtaining a substrate that is more advantageous in terms of the high-frequency characteristics. The upper limit of the resistivity is not particularly limited, and the higher the value is, the more the high-frequency characteristics can be improved. For example, the resistivity may be 50k Ω·cm.

The TR layer 5 is a layer having an effect of trapping charge by defects in the layer, and may be a layer having this function. Examples of the TR layer 5 include a non-doped polysilicon layer, a damaged layer formed on the surface of the base substrate by ion implantation.

The oxide film 6 may be, for example, a silicon oxide film formed by thermal oxidation.

The SOI layer 7 has the resistivity of 1k Ω·cm or more, the crystal plane orientation of (111), and the oxygen concentration of 14.8 ppma or less.

Because the resistivity is as high as 1k Ω·cm or more, the high-frequency characteristics of the high-frequency device substrate 1 are improved. The resistivity may be preferably 3k Ω·cm or more, and more preferably 5k Ω·cm or more, for obtaining a substrate that is more advantageous in terms of the high-frequency characteristics. The upper limit of the resistivity is not particularly limited, and the higher the value is, the more the high-frequency characteristics can be improved. For example, the resistivity may be 150k Ω·cm.

Moreover, because the crystal plane orientation is (111), a good nitride semiconductor film can be suitably formed on the SOI layer 7.

Furthermore, as described above, the present inventor found that the high-frequency characteristics depend on the oxygen concentration in the SOI layer 7, and when the oxygen concentration is 14.8 ppma or less, high-frequency characteristics superior to those of conventional products can be obtained.

For example, with respect to the second harmonic (2HD), the improvement reaches a limit at about -91 dBm in conventional products, but the present invention can achieve further improvement. For example, the 2HD can be improved by reducing to about -95 dBm. When the oxygen concentration is 5.2 ppma or less, the 2HD can be improved to, for example, about -105 dBm. When the oxygen concentration is 0.5 ppma or less, the 2HD can be improved to, for example, about -115 dBm, or further improvement is possible. Note that the lower the oxygen concentration is, the more preferable it is in terms of improvement in the high-frequency characteristics. Thus, the lower limit cannot be set.

In the specification of the present application, the oxygen concentration values in the present invention (and oxygen concentration values in conventional products of Comparative Examples described later) are based on the JEIDA-61-2000 standard.

The nitride semiconductor film 3 is not particularly limited, and a nitride semiconductor in accordance with the purpose can be employed. Examples thereof include GaN, AlN, AlGaN, or a combination thereof.

The high frequency device substrate 1 of the present invention as described above is superior to conventional products in terms of the high frequency characteristics.

Next, a method for producing the high frequency device substrate of the present invention, by which the high frequency device substrate 1 shown in FIG. 1 can be produced, will be described. FIG. 2 is a process flow of the production method according to an embodiment of the present invention. The process flow includes a step of preparing the TRSOI substrate and a step of forming the nitride semiconductor film.

Hereinafter, each step will be described in detail by showing specific examples.

### <Preparation of TRSOI substrate>

First, a base substrate is prepared, and a TR layer is formed thereon.

For example, a base substrate (Si substrate) having a high resistivity (1 to 50k Ω·cm) with a diameter of 150 mm is prepared. In particular, a silicon single crystal ingot having <100> crystal axis orientation may be grown by the Czochralski method, and the ingot may be sliced by a wire saw apparatus to prepare a silicon single crystal substrate having (100) crystal plane orientation (base substrate: (100) just substrate). Note that the (100) just substrate is described here as an example for the base substrate as described above, but the base substrate having an off angle may also be used.

On the base substrate thus prepared, a poly-Si layer serving as a trap rich layer (TR layer) is grown by a low-pressure CVD method to a thickness of 100 nm to 3 µm. As examples of the growing conditions, the temperature inside a reaction tube of a vapor phase growth apparatus may be set to, e.g. 590°C or more, and for example, monosilane (SiH₄) gas and phosphine (PH₃) gas may be introduced into the reaction tube, thereby growing the layer while maintaining the inside of the reaction tube at a predetermined vacuum degree. Alternatively, there is also a method in which an amorphous silicon film is formed at a temperature of 580°C or less using disilane (Si₂H₆) gas, and this thin film is annealed at a temperature of, e.g. about 600 to 1000°C, to be polycrystallized.

As described above, the TR layer is a layer having an effect of trapping charge by defects in the layer, and is not limited to polysilicon as long as this function is provided. For example, a damaged layer formed in a Si crystal by ion implantation can be used. For example, the damaged layer can be formed on the surface of the base substrate.

Next, a bond substrate composed of a silicon single crystal is prepared, and the base substrate and the bond substrate are bonded to each other via an oxide film, thereby obtaining a bonded substrate. Then, the bond substrate in the bonded substrate is thinned to form an SOI layer (production of a TRSOI substrate).

First, the bond substrate is prepared. For example, a CZ single crystal substrate or an FZ single crystal substrate may be used. The bond substrate is to be the SOI layer later, and the nitride semiconductor film is laminated thereon. Therefore, one having the crystal plane orientation of (111) is prepared. For example, an ingot having a crystal axis orientation of <111> may be grown by appropriately adjusting ingot production conditions in the CZ method or the FZ method, and then sliced (bond substrate: (111) just substrate).

Note that the bond substrate may have an off-angle, and the off-angle is particularly preferably within ± 1°. In this case, the nitride semiconductor film formed thereon can be more reliably made uniform and of high quality.

At this time, the dopant concentration is appropriately adjusted to obtain high resistivity (1k Ω·cm or more).

Further, the oxygen concentration in the crystal is controlled to 14.8 ppma or less. In the CZ method, the oxygen concentration in the ingot can be adjusted by, for example, adjusting the rotation speed of a crucible in a CZ pulling apparatus, and can be more preferably adjusted to 5.2 ppma or less. In the FZ method, in particular, a material having a low oxygen concentration such as 0.5 ppma or less can be easily prepared. By reducing the oxygen concentration in the bond substrate (SOI layer), the high-frequency characteristics can be further improved, and the 2HD can be further reduced.

Then, for example, a 200 nm oxide film (to be a BOX film) is formed on the polysilicon layer, which is formed on the base substrate, and joined (bonded) to the (111) bond substrate (1 to 150k Ω·cm, preferably 3k Ω·cm or more, more preferably 5k Ω·cm or more) to be an SOI layer, and then the bond substrate is thinned to form the SOI layer. The thickness of the SOI layer may be, for example, 100 nm.

The oxide film can be formed such that the thickness of the oxide film between the base single crystal substrate and the bond single crystal substrate is, for example, 2 nm or more and 470 nm or less. As a matter of course, the thickness of the oxide film after the substrates are joined to each other can be 2 nm or more and 470 nm or less. Note that the oxide film may be formed on a side of the polysilicon layer that is formed on the base substrate, or on a side of the bond substrate. Alternatively, the oxide film may be formed on the both sides.

Conditions (atmosphere, temperature, time or the like) of the heat treatment (joining heat treatment) are not particularly limited as long as the base substrate and the bond substrate can be joined to each other. The joining heat treatment may be carried at a temperature of e.g. 400°C or more and 1200°C or less in a nitrogen atmosphere for 1 to 12 hours.

Examples of a method for thinning the bond substrate include an ion implantation delamination method. An ion-implanted layer may be formed in the bond substrate in advance, and the bonded substrate after bonding may be delaminated at the ion-implanted layer by delamination heat treatment or may be mechanically delaminated at the ion-implanted layer.

### <Formation of Nitride Semiconductor Film>

After the TRSOI substrate is prepared as described above, a nitride semiconductor film is formed on the SOI layer.

For example, an AlN initial layer, an AlGaN layer, a GaN layer, and an SLs layer (superlattice layer of AlGaN/GaN or AlN/GaN) are laminated on the TRSOI substrate, and a GaN layer is laminated thereon so as to have a total thickness of 1.8 µm. These layers can be formed by epitaxial growth by the MOCVD method.

Note that a thermal donor due to oxygen in the substrate is unlikely to occur. This is because the epitaxial growth temperature is about 1200 to 1050, a thermal history of at least 4 hours is added, and thus a thermal donor is considered not to be formed. Moreover, cooling is close to rapid cooling.

In the present invention, the numerical values of the film thickness, resistivity, process temperature, and the like of each part, other than the resistivity (1k Ω·cm or more), the crystal plane orientation (111), and the oxygen concentration (14.8 ppma or less) in the SOI layer, which are described in the description of the above process, are not limitative. They are merely examples.

According to the production method of the present invention as described above, it is possible to produce the high-frequency device substrate 1 having improved high-frequency characteristics as compared with the prior art. Thus, the substrate in which the 2HD is further reduced than -91 dBm can be obtained.

### EXAMPLE

Hereinafter, the present invention will be more specifically described with reference to Examples and Comparative Examples. However, the present invention is not limited to these Examples.

### (Example 1)

The high-frequency device substrate 1 shown in FIG. 1 (TRSOI substrate + nitride semiconductor film) was produced according to the flow of FIG. 2.
Base substrate 4: CZSi single crystal substrate, (100) plane as a main surface, 8k Ω·cm
TR layer 5: polysilicon layer, 1.8 µm in thickness
Oxide film 6 (BOX film): 200 nm in thickness
SOI layer 7 (bond substrate): CZSi single crystal, (111) plane as a main surface, 5k Ω·cm, oxygen concentration 14.8 ppma, 100 nm in thickness
Nitride semiconductor film 3: A buffer layer composed of an AlN initial layer, an AlGaN layer and an SLs structure of GaN/AlN is laminated, and a GaN layer is laminated thereon; 1.8 µm in total thickness

Production conditions of the TR layer, the oxide film, the SOI layer, and the nitride semiconductor film are as follows.

TR layer: A polysilicon layer was formed as a trap rich layer (charge trapping layer) on the base substrate at 1050°C, and then the surface thereof was polished to a thickness of 1.8 µm.

Oxide film: The oxide film was formed by thermal oxidation of the bond substrate.

SOI layer: Hydrogen was implanted from the upper surface (side to be bonded to the base substrate) of the bond substrate to form a microbubble layer (ion-implanted layer) inside the bond substrate. The bond substrate having the microbubble layer was attached to the surface of the polysilicon layer of the base substrate formed in advance. Then, a heat treatment was performed to split the bond substrate using the microbubble layer as a delamination interface, thereby forming a thin bond layer remaining on the oxide film, that is, an SOI layer. Thereafter, the SOI layer was subjected to touch polishing to obtain the SOI layer having a film thickness of 100 nm.

Nitride semiconductor: The growth temperature of each layer is as follows. The initial layer AlN was grown at 1050 to 1200°C, the AlGaN layer was grown at 1150 to 1050°C, the SLs structure was grown at 1100 to 1000°C, and the GaN was grown at 1000 to 900°C.

An RF electrode was formed on the above high-frequency device substrate to evaluate characteristics.

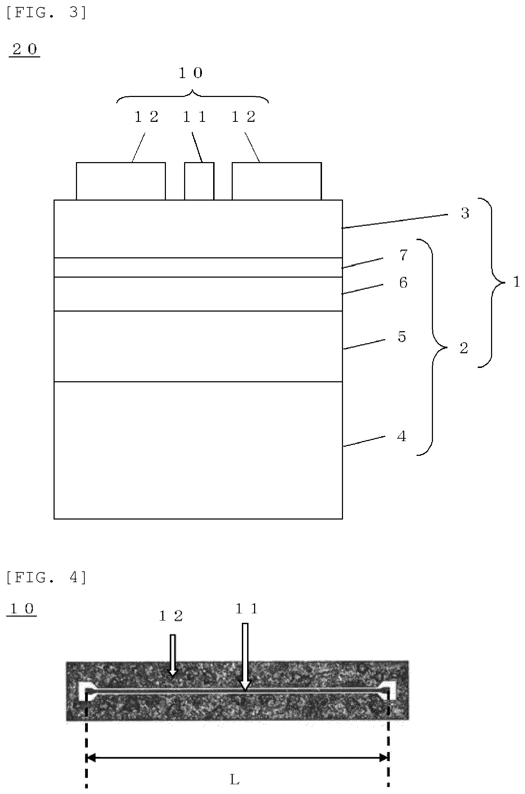

Specifically, an Al electrode (thickness: 1 µm, length: 2199 µm) of a CPW (Co-Planar Waveguide) was formed on the high-frequency device substrate 1 by a photolithography process, and a heat treatment was performed. In this manner, a composite 20 shown in FIG. 3 (structural view) and FIG. 4 (plan view) was obtained.

The composite 20 included the high-frequency device substrate 1 and a CPW electrode 10 formed on the surface of the nitride semiconductor film 3.

The CPW electrode 10 included a central electrode 11 having a length L (FIG. 4) of 2199 µm and a width of 15 µm, and a peripheral electrode 12. The thickness of the central electrode 11 and the peripheral electrode 12 was 1 µm.

The CPW electrode 10 was used to obtain harmonic characteristics (2HD) as the RF characteristics of the high frequency device substrate 1.

As regarding the measurement conditions, the shape of the CPW electrode 10, and the output Pₒᵤₜ = 15 dBm at the fundamental frequency (H1) f0 = 0.9 GHz were the same in Example 1 and each of Examples and Comparative Examples described later.

In Example 1, the result was -95 dBm.

### (Example 2)

A high-frequency device substrate and a CPW electrode were produced in the same manner as in Example 1 except that the oxygen concentration in the SOI layer was 5.2 ppma, and the harmonic characteristics (2HD) were obtained.

The result was -104.8 dBm.

### (Example 3)

A high-frequency device substrate and a CPW electrodes were produced in the same manner as in Example 1 except that the oxygen concentration in the SOI layer was 0.3 ppma (bond substrate was an FZSi single crystal), and the harmonic characteristics (2HD) were obtained.

The result was -114.2 dBm.

### (Comparative Example 1)

A high-frequency device substrate and a CPW electrode were produced in the same manner as in Example 1 except that the resistivity of the base substrate was 5k Ω·cm and the oxygen concentration in the SOI layer was 17.1 ppma, and the harmonic characteristics (2HD) were obtained.

The result was -89.9 dBm.

### (Comparative Example 2)

A GaN on Si structure was produced. Specifically, as the nitride semiconductor film, the buffer layer having the SLs structure or the like was laminated on a Si substrate (FZSi single crystal substrate, (111) plane as a main surface, 5k Ω·cm, oxygen concentration of 0.5 ppma) and the GaN layer was laminated thereon in the same manner as in Example 1. The total thickness was 1.8 µm.

Although the nitride semiconductor film is included in Comparative Example 2, Comparative Example 2 is different from Examples, which are the products of the present invention, in that the nitride semiconductor film is formed on the Si substrate and not on the TRSOI substrate.

A CPW electrode was produced in the same manner as in Example 1, and the harmonic characteristics (2HD) were obtained.

The result was -84 dBm.

### (Comparative Example 3)

In order to evaluate a high-frequency characteristics of a TR substrate, an SOI layer was removed from a TRSOI substrate, and the TR substrate with an oxide film was produced. Specifically, the TRSOI substrate was produced by: forming a polysilicon layer with a thickness of 1.8 µm on a Si substrate ((100) plane as a main plane, 5k Ω·cm, and oxygen concentration of 13.1 ppma) of a base substrate; forming an oxide film with a thickness of 200 nm on a Si substrate of a bond substrate and a microbubble layer in the Si substrate of the bond substrate; attaching the oxide film side of the bond substrate to the surface of the polysilicon layer of the base substrate; performing a heat treatment; and splitting the bond substrate using the microbubble layer as a delamination interface to form the SOI layer; and thinning the SOI layer by touch polishing. Thereafter, the SOI layer was delaminated to obtain the TR substrate with an oxide film.

A CPW electrode was produced on the oxide film of the TR substrate with an oxide film in the same manner as in Example 1, and the harmonic characteristics (2HD) were obtained.

The result was -91 dBm.

Note that Comparative Example 3 is different from Examples, which are the products of the present invention, in that it does not have the SOI layer 7 and the nitride semiconductor film that are included in the products of the present invention.

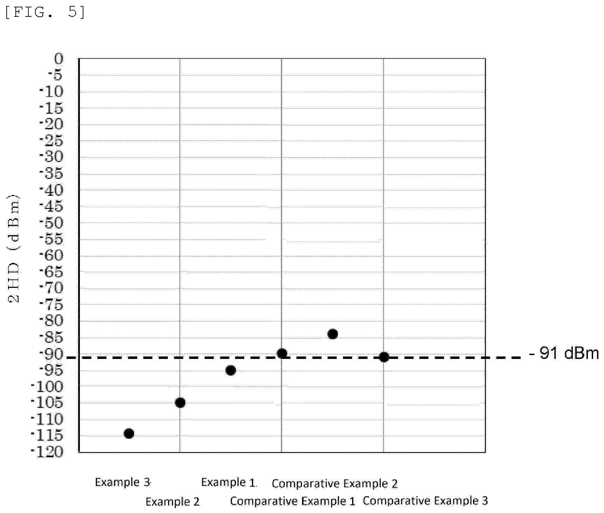

The measurement results of the harmonic characteristics (2HD) of Examples 1 to 3 and Comparative Examples 1 to 3 are shown in FIG. 5. Among Comparative Examples 1 to 3, the 2HD was most reduced in Comparative Example 3, but remained at -91 dBm. On the other hand, in Examples 1 to 3 in which the present invention was carried out, the 2HD could all be reduced exceeding -91 dBm, which were extremely favorable results.

### (Example 4)

A high-frequency device substrate and a CPW electrode were produced in the same manner as in Example 1 except that the oxygen concentration in the SOI layer was 0.5 ppma (bond substrate was an FZSi single crystal), and the harmonic characteristics (2HD) were obtained.

The result was -112.4 dBm.

### (Example 5)

A high-frequency device substrate and a CPW electrode were produced in the same manner as in Example 1 except that the resistivity of the SOI layer was 1k Ω·cm, and the harmonic characteristics (2HD) were obtained.

The result was -94 dBm.

### (Comparative Example 4)

A high-frequency device substrate and a CPW electrode were produced in the same manner as in Example 1 except that the oxygen concentration in the SOI layer was 17.1 ppma, and the harmonic characteristics (2HD) were obtained.

The result was -89.6 dBm.

In Examples 4 and 5, the 2HD could also be reduced exceeding -91 dBm. On the other hand, Comparative Example 4 did not reach -91 dBm of Comparative Example 3.

The present description encompasses the following embodiments.
[1]: A high-frequency device substrate comprising an SOI substrate with a nitride semiconductor film formed thereon, wherein
   the SOI substrate is a TRSOI substrate in which a trap rich layer formed on a base substrate and an SOI layer composed of a silicon single crystal are bonded via an oxide film, and
   the SOI layer has a resistivity of 1k Ω·cm or more, a crystal plane orientation of (111), and an oxygen concentration of 14.8 ppma or less.
[2]: The high-frequency device substrate according to [1], wherein the SOI layer has an oxygen concentration of 5.2 ppma or less.
[3]: The high-frequency device substrate according to [1], wherein the SOI layer has an oxygen concentration of 0.5 ppma or less.
[4]: The high-frequency device substrate according to any one of [1] to [3], wherein the base substrate is a CZ silicon single crystal substrate having a crystal plane orientation of (100).
[5]: The high-frequency device substrate according to any one of [1] to [4], wherein the base substrate has a resistivity of 1k Ω·cm or more.
[6]: A method for producing a high-frequency device substrate comprising an SOI substrate with a nitride semiconductor film formed thereon, the method comprising:
   a step of providing, as the SOI substrate, a TRSOI substrate in which in a bonded substrate obtained by bonding a trap rich layer formed on a base substrate and a bond substrate composed of a silicon single crystal via an oxide film, the bond substrate is thinned to form an SOI layer; and
   a step of forming the nitride semiconductor film on the SOI layer, wherein
   the bond substrate has a resistivity of 1k Ω·cm or more, a crystal plane orientation of (111), and an oxygen concentration of 14.8 ppma or less.
[7]: The method for producing the high-frequency device substrate according to [6], wherein a substrate having an oxygen concentration of 5.2 ppma or less is used as the bond substrate.
[8]: The method for producing the high-frequency device substrate according to [6], wherein a substrate having an oxygen concentration of 0.5 ppma or less is used as the bond substrate.
[9]: The method for producing the high-frequency device substrate according to any one of [6] to [8], wherein a CZ silicon single crystal substrate having a crystal plane orientation of (100) is used as the base substrate.
[10]: The method for producing the high-frequency device substrate according to any one of [6] to [9], wherein a substrate having a resistivity of 1k Ω·cm or more is used as the base substrate.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A high-frequency device substrate comprising an SOI substrate with a nitride semiconductor film formed thereon, wherein
the SOI substrate is a TRSOI substrate in which a trap rich layer formed on a base substrate and an SOI layer composed of a silicon single crystal are bonded via an oxide film, and
the SOI layer has a resistivity of 1k Ω·cm or more, a crystal plane orientation of (111), and an oxygen concentration of 14.8 ppma or less.

2. The high-frequency device substrate according to claim 1, wherein the SOI layer has an oxygen concentration of 5.2 ppma or less.

3. The high-frequency device substrate according to claim 1, wherein the SOI layer has an oxygen concentration of 0.5 ppma or less.

4. The high-frequency device substrate according to any one of claims 1 to 3, wherein the base substrate is a CZ silicon single crystal substrate having a crystal plane orientation of (100).

5. The high-frequency device substrate according to any one of claims 1 to 3, wherein the base substrate has a resistivity of 1k Ω·cm or more.

6. The high-frequency device substrate according to claim 4, wherein the base substrate has a resistivity of 1k Ω·cm or more.

7. A method for producing a high-frequency device substrate comprising an SOI substrate with a nitride semiconductor film formed thereon, the method comprising:
a step of providing, as the SOI substrate, a TRSOI substrate in which in a bonded substrate obtained by bonding a trap rich layer formed on a base substrate and a bond substrate composed of a silicon single crystal via an oxide film, the bond substrate is thinned to form an SOI layer; and
a step of forming the nitride semiconductor film on the SOI layer, wherein
the bond substrate has a resistivity of 1k Ω·cm or more, a crystal plane orientation of (111), and an oxygen concentration of 14.8 ppma or less.

8. The method for producing the high-frequency device substrate according to claim 7, wherein a substrate having an oxygen concentration of 5.2 ppma or less is used as the bond substrate.

9. The method for producing the high-frequency device substrate according to claim 7, wherein a substrate having an oxygen concentration of 0.5 ppma or less is used as the bond substrate.

10. The method for producing the high-frequency device substrate according to any one of claims 7 to 9, wherein a CZ silicon single crystal substrate having a crystal plane orientation of (100) is used as the base substrate.

11. The method for producing the high-frequency device substrate according to any one of claims 7 to 9, wherein a substrate having a resistivity of 1k Ω·cm or more is used as the base substrate.

12. The method for producing the high-frequency device substrate according to claim 10, wherein a substrate having a resistivity of 1k Ω·cm or more is used as the base substrate.
